# EUROPÄISCHE PATENTANMELDUNG

(11) **EP 2 608 285 A1**
(43) Veröffentlichungstag der Anmeldung: **26.06.2013**
(21) Anmeldenummer: 12196345.8
(22) Anmeldetag: 10.12.2012
(51) Int. Cl.: H01L 33/62, H01L 33/60

(54) **Leuchtdiodenanordnung**

(30) Priorität: 20.12.2011 DE 102011056654
(71) Anmelder: Vossloh-Schwabe Optoelektronik GmbH & Co. KG, 47475 Kamp Lintfort (DE)
(72) Erfinder: Cladders, Olaf, 47475 Kamp-Lintfort (DE); Kwetkat, Stefan, 46487 Wesel (DE); Miesner, Christian, 47918 Tönisvorst (DE); Neu, Volker, 50733 Köln (DE)
(74) Vertreter: Rüger, Barthelt & Abel

(57) **Zusammenfassung**

Eine Leuchtdiodenanordnung (10) weist einen Reflektor auf, auf dem eine oder mehrere Leuchtdioden angeordnet sind. Der Reflektor ist mit einer Leiterplatte verbunden, die Leiterzüge zur Stromversorgung der Leuchtdiode trägt. Außerdem können auf der Leiterplatte elektronische Komponenten, bspw. zur Begrenzung oder Regelung des Leuchtdiodenstroms, angeordnet sein. Weitere elektronische Komponenten bspw. zur Temperaturüberwachung, Helligkeitsregelung, Farbüberwachung und dergleichen, können ebenfalls auf der Leiterplatte (14) platziert sein. An den an der Rückseite (17) angeordneten Reflektor (11) kann ein Kühlkörper (37) angeordnet sein. An der Vorderseite (16) der Leiterplatte (14) kann ebenfalls ein Reflektor (35) angeordnet sein. Die Leiterplatte (14) weist im Bereich des Reflektors (11) eine Öffnung (15) auf, innerhalb derer die Leuchtdioden (12,13) usw., angeordnet sind.

## Beschreibung

Die Erfindung betrifft eine Leuchtdiodenanordnung, zur Integration in eine Leiterplatte.

Werden lichterzeugende Halbleiterbauelemente, die allgemein auch als LEDs bezeichnet werden, als Lichtquellen zu Beleuchtungszwecken eingesetzt, kann davon ausgegangen werden, dass die LEDs, anders als herkömmliche Lichtquellen, auf absehbare Zeit nicht ausgetauscht werden müssen. Während herkömmliche Leuchtmittel in Fassungen angeordnet werden, aus denen sie mit vertretbarem Aufwand zu entnehmen sind, so dass sie leicht ausgewechselt werden können, ist dies bei LEDs nicht erforderlich. Andererseits genügt der Lichtstrom einer einzelnen LED meist nicht zur Erzeugung der gewünschten Helligkeit an einem bestimmten Ort. Es werden deshalb üblicherweise mehrere LEDS zu einem LED-Bauelement vereint. Dieses muss allerdings dazu geeignet sein, die von den LEDs ausgehende erhebliche Verlustwärme abzuführen.

Die EP 2 348 244 A2 schlägt eine Leuchtdiodenanordnung vor, die auf einer Grundplatte ausgebildet ist. Die Grundplatte trägt mehrere, jeweils nach Art einer flachen Tasse ausgebildete Sockel, die auf der Grundplatte befestigt sind. In der Ausnehmung der tassenartigen Sockel ist jeweils ein LED-Chip angeordnet und vergossen. Über dem Sockel wölbt sich jeweils eine lichtdurchlässige Haube. In der Haube kann ein Leuchtstoff untergebracht sein, um von der LED ausgehendes Licht in der Farbe zu verändern.

Die Baueinheit wird in einem Gehäuse angeordnet. Zur Anordnung auf einer Leiterplatte ist sie wegen der dann auftretenden Kühlprobleme weniger vorgesehen.

Es ist Aufgabe der Erfindung, ein Konzept anzugeben, mit dem sich einerseits eine hohe Lichtausbeute erzielen lässt und das andererseits eine kostengünstige unkomplizierte Fertigung gestattet.

Diese Aufgabe wird mit der Leuchtdiodenanordnung nach Anspruch 1 gelöst:

Die erfindungsgemäße Leuchtdiodenanordnung umfasst einen Reflektor, auf dem wenigstens ein Leuchtdiodenchip als Nacktchip angeordnet ist, wobei dieser Reflektor mit einer Leiterplatte verbunden ist und wenigstens ein Bonddraht zur Stromversorgung des Leuchtdiodenchips von dem Chip zu einer Leiterbahn der Leiterplatte führt.

In diesem Zusammenhang wird unter dem Begriff "Leuchtdiode" oder synonym unter einer LED jedes elektronische Festkörperbauelement verstanden, das bei Stromdurchfluss auf nicht thermischem Weg Licht erzeugt. Im engeren Sinne wird unter einer Leuchtdiode jedes Bauelement verstanden, das mindestens einen lichtemittierenden pn-Übergang aufweist. Das Licht kann dabei eine Wellenlänge im sichtbaren Spektralbereich oder auch im unsichtbaren Spektralbereich haben.

Die Leiterplatte ist ein wenig flexibles, vorzugsweise plattenartiges, auf einem Kunststoff, bspw. glasfaserverstärktem Kunststoff, basierendes Element, das auf mindestens einer Flachseite Leiterzüge trägt. Die Leiterplatte weist vorzugsweise mindestens eine Öffnung auf, die wesentlich größer ist als eine einzelne Leuchtdiode. In oder an der Öffnung ist der Reflektor vorgesehen, der eine oder mehrere Nacktchip-Leuchtdioden trägt. Vorzugsweise ist der Reflektor frei von Leiterzügen. Die Leuchtdiode (oder mehrere Leuchtdioden) sind auf den Reflektor aufgeklebt oder aufgelötet oder anderweitig mit diesem verbunden.

Zur Stromversorgung der Leuchtdiode führt mindestens ein Bonddraht von einem Leiterzug der Leiterplatte zu der Leuchtdiode. Der Leiterzug ist dabei vorzugsweise auf derjenigen Seite der Leiterplatte angeordnet, die in Lichtaustrittsrichtung weist. Diese Seite wird nachstehend als Vorderseite der Leiterplatte bezeichnet. Die in Gegenrichtung weisende Flachseite wird nachstehend als Rückseite der Leiterplatte bezeichnet. Die weitere Kontaktierung der Leuchtdiode kann durch einen zweiten Bonddraht erfolgen, der ebenfalls von der Leuchtdiode zu einem Leiterzug der Leiterplatte oder auch von der Leuchtdiode zu einer anderen auf dem Reflektor angeordneten Leuchtdiode führt. Es können auf dem Reflektor weitere Leuchtdioden angeordnet sein, die durch ein oder zwei Bonddrähte kontaktiert sind, wobei die Bonddrähte bspw. zu benachbarten Leuchtdioden führen. Weiter kann der Reflektor zur Stromversorgung der Leuchtdioden genutzt werden. Dazu kann der Reflektor elektrisch mit einem Leiterzug der Leiterplatte verbunden sein. Weiter können die Leuchtdioden mit dem Reflektor elektrisch leitend verbunden sein.

Alternativ ist es möglich, auf dem Reflektor einen oder mehrere Leiterzüge vorzusehen, die der Stromversorgung der Leuchtdioden dienen. Dies wird allerdings bei der bevorzugten Ausführungsform vermieden, um die Lichtreflexionseigenschaften des Reflektors nicht zu beeinträchtigen.

Der Reflektor ist vorzugsweise ein Spiegel, der eine gerichtete Lichtreflexion aufweist. Alternativ kann der Reflektor auch ein diffus reflektierender Reflektor sein. Jedenfalls aber zeichnet er sich durch eine geringe Lichtabsorption im Bereich des von der LED erzeugten und des auszusendenden Lichts aus.

Vorzugsweise ist der Reflektor an der Rückseite der Leiterplatte angebracht, wobei er die in der Leiterplatte vorgesehene Öffnung überspannt, d.h. zumindest teilweise überdeckt. Der Reflektor weist dann eine vorzugsweise ebene Chipaufnahmefläche und einen Randbefestigungsabschnitt auf, der die Chipaufnahmefläche umgibt oder seitlich an diese anschließt. Die Chipaufnahmefläche und der Rand können in einer gemeinsamen Ebene liegen. Es ist jedoch auch möglich, den Rand abzuwinkeln, so dass der Rand und die Chipaufnahmefläche bspw. in einem stumpfen Winkel zueinander stehen. Weiter ist es möglich, den Rand mit mindestens einer oder auch mehreren Öffnungen zu versehen, durch die Bonddrähte von den Leuchtdioden zu Leiterzügen der Leiterplatte geführt werden können. Diese Maßnahme kann dabei hilfreich sein, aus den Leuchtdioden in Seitenrichtung austretendes Licht in gewünschter Weise zu reflektieren.

Weitere Einzelheiten vorteilhafter Ausführungsformen der Erfindung sind Gegenstand der Beschreibung, der Zeichnung oder von Ansprüchen. Es zeigen:
Figur 1 ein Ausführungsbeispiel einer erfindungsgemäßen Leuchtdiodenanordnung, in ausschnittsweise schematisierter Schnittdarstellung,
Figur 2 die Leuchtdiodenanordnung nach Figur 1, in Perspektivdarstellung,
Figur 3 eine Variante einer Leuchtdiodenanordnung nach Figur 1 oder 2, in vergrößerter ausschnittsweiser Prinzipdarstellung,
Figur 4 eine Leuchtdiodenanordnung mit mehreren auf dem Reflektor angeordneten Leuchtdioden in Reihenschaltung, in ausschnittsweiser perspektivischer Darstellung,
Figur 5 eine abgewandelte Ausführungsform einer Leuchtdiodenanordnung mit mehreren Leuchtdioden in Reihenschaltung, in perspektivischer ausschnittsweiser Anordnung,
Figur 6 eine weitere Ausführungsform einer Leuchtdiodenanordnung mit einer größeren Anzahl von auf dem Reflektor angeordneten Leuchtdioden, in schematisierter Draufsicht,
Figur 7 eine bspw. auf der Leuchtdiodenanordnung nach Figur 6 beruhende Leuchtdiodenanordnung mit Zusatzreflektor und Kühlkörper, in schematisierter Seitenansicht,
Figur 8 eine Leuchtdiodenanordnung mit nicht ebenem Reflektor und externer Kontaktierung, in Prinzipdarstellung,
Figur 9 eine Leuchtdiodenanordnung mit nicht ebenem Reflektor und Leiterbahn auf dem Reflektor, in geschnittener ausschnittsweiser Prinzipdarstellung, und
Figur 10 eine Ausführungsform der Leuchtdiodenanordnung mit einem Reflektor, der mindestens eine Öffnung zur Durchführung eines Bonddrahts aufweist, in geschnittener ausschnittsweiser perspektivischer Darstellung.

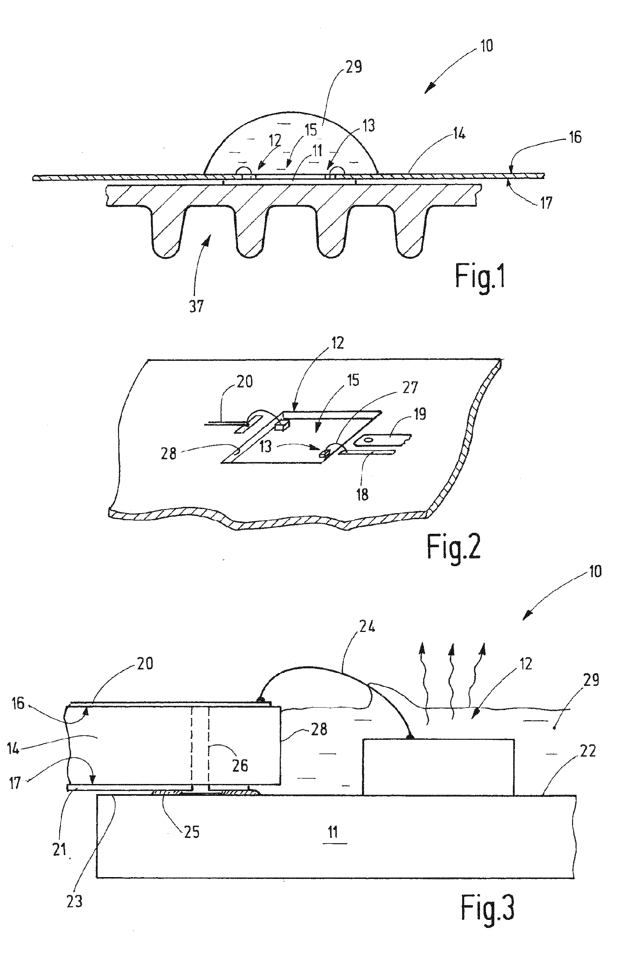

In Figur 1 ist eine Leuchtdiodenanordnung 10 veranschaulicht, die mindestens eine oder auch mehrere auf einem Reflektor 11 angeordnete Leuchtdioden 12, 13 umfasst. Bei den Leuchtdioden 12, 13 handelt es sich dabei um sogenannte Nacktchips, d.h. Halbleiterkörper mit darin eingebetteten lichterzeugenden Strukturen ohne eigene Verkapselung.

Der Reflektor 11 ist mit einer Leiterplatte 14 verbunden, die mindestens eine größere Ausnehmung 15, z.B. in Gestalt eines runden oder polygonal begrenzten Lochs, aufweist. Die Leiterplatte 14 besteht bspw. aus einem faserverstärkten Kunststoffmaterial oder einem sonstigen vorzugsweise nichtmetallischen elektrisch isolierenden Träger. Die Leiterplatte 14 ist vorzugsweise als steife, z.B. ungefähr 2 mm dicke Platte ausgebildet, die eine Vorderseite 16 und eine Rückseite 17 aufweist. Unabhängig von den vorgenannten Merkmalen ist die Platte 14 vorzugsweise eben ausgebildet. Es können auch flexible Leiterplatten aus Polyamid, PET o.ä. mit geringer Dicker zum Einsatz kommen. Die Leiterplatte 14 trägt vorzugsweise an ihrer Vorderseite 16 Leiterzüge 18, 19, 20. Optional oder alternativ können ein oder mehrere Leiterzüge 21 an der Rückseite 17 vorgesehen sein, wie es bspw. in Figur 3 veranschaulicht ist.

Der Reflektor 11 ist vorzugsweise mit der Rückseite 17 der Leiterplatte 14 verbunden. Dabei ist der Reflektor 11 vorzugsweise so im Bereich der Öffnung 15 angeordnet, dass seine zentrale Chipaufnahmefläche 22 innerhalb der Öffnung 15 steht. Vorzugsweise ist die Chipaufnahmefläche 22 eben ausgebildet. Die Chipaufnahmefläche 22 ist von einem Rand 23 umgeben, der wenigstens an einer oder an mehreren Stellen mit der Leiterplatte 11, vorzugsweise mit der Rückseite der Leiterplatte 11 verbunden ist. Wie Figur 1 und 3 zeigen, sind der Rand 23 und die Chipaufnahmefläche 22 vorzugsweise in einer gemeinsamen Ebene angeordnet.

Auf der Chipaufnahmefläche 22 sind die Leuchtdioden 12, 13 sowie gegebenenfalls weitere Leuchtdioden angeordnet. Als Leuchtdioden 12, 13 kommen sowohl Leuchtdioden mit vertikalem als auch Leuchtdioden mit horizontalem pn-Übergang in Frage. Die Leuchtdioden 12, 13 können jeweils einen oder auch mehre pn-Übergänge enthalten. Vorzugsweise geht bei Stromdurchfluss von diesen pn-Übergängen Licht aus, das, wie Figur 3 andeutet, von dem Reflektor 11 weg abgestrahlt wird. Sofern die Leuchtdioden 12, 13 das austretende Licht nicht stark bündeln, trifft ein Teil des emittierten Lichts auch auf den Reflektor 22 und wird von diesem zurückgeworfen, was der Lichtausbeute zugute kommt.

Figur 1 bis 3 veranschaulicht eine Bauform der Leuchtdiodenanordnung 10, bei der die Leuchtdiode 12 (13) einen vorderseitigen, über einen Bonddraht 24 stromversorgten Kontakt und einen rückseitigen Kontakt aufweist, der über den Reflektor 11 mit Strom versorgt wird. Dazu ist der Reflektor 11 mit einem Leiterzug der Leiterplatte 14 elektrisch leitend verbunden. Beispielsweise kann dazu der Leiterzug 21 dienen, der mittels eines geeigneten Lots 25, mittels eins leitenden Klebers oder mittels eines sonstigen geeigneten Kontaktmittels einschließlich Federn, Klemmen, Schrauben oder dergleichen, elektrisch mit dem Reflektor 11 verbunden ist. Zusätzlich oder alternativ kann eine in Figur 3 gestrichelt angedeutet Durchkontaktierung 26 vorgesehen sein, die an der Rückseite 17 mit dem Reflektor 11 verlötet ist und diesen elektrisch mit einem nicht weiter veranschaulichten an der Vorderseite 16 angeordneten Leiterzug verbindet.

Die gegebenenfalls vorhandene wenigstens eine weitere Leuchtdiode 13 kann auf jede der genannten Weisen über einen Bonddraht 27 mit einem Leiterzug, bspw. dem Leiterzug 18 verbunden sein.

Die Leuchtdioden 12, 13 sind bei dieser Ausführungsform und vorzugsweise auch bei nachfolgend beschriebenen Ausführungsformen unterhalb der Vorderseite 16 angeordnet. Sie befinden sich somit in der Öffnung 15. Die Randfläche 28 (Figur 3) der Öffnung 15 umgibt eine flache Tasche, die unten von dem Reflektor 11 abgeschlossen ist. diese Tasche kann durch einen Verguss 29 geschlossen sein, der wie bspw. Figur 3 zeigt, durchaus unterhalb der Vorderseite 16 bleiben kann. Die Bonddrähte 24 (27) ragen dann aus dem Verguss 29 heraus. Allerdings bleiben die Bonddrähte 24, 27 vorzugsweise nicht ganz ungeschützt. Bei der Herstellung des Vergusses 29 kann die Vergussmasse, wie in Figur 3 dargestellt, den Bonddraht 24 wenigstens teilweise benetzen und so eine Hülle für diesen bilden. Es können aber durchaus auch Teile des Bonddrahts 24 frei liegen. Alternativ kann der Verguss 29, wie in Figur 1 dargestellt, die Öffnung 15 komplett überwölben. Der Verguss 29 kann klar ausgebildet sein. Alternativ kann er Streukörper und/oder Mittel zur Lichtumsetzung enthalten, bspw. in Gestalt dispergierter Leuchtstoffe, die vorzugsweise blaues oder nahes ultraviolettes Licht in oranges und/oder gelbes Licht umsetzen. Die Leuchtstoffe sind vorzugsweise so abgestimmt, dass das die Leuchtdiodenanordnung 10 verlassende Mischlicht als weißes Licht wahrgenommen wird. Alternativ oder ergänzend können die Leuchtdioden 12, 13 und gegebenenfalls weitere LEDs unterschiedliche Lichtfarbe emittieren, um gemeinsam einen weißen Lichteindruck hervorzurufen.

Bei der Ausführungsform nach den Figuren 1 bis 3 weisen die Leuchtdioden 12 und 13 den Reflektor 11 als gemeinsame sie elektrisch miteinander verbindende Elektrode auf. Es können somit beliebig viele Leuchtdioden elektrisch parallel geschaltet werden. Jedoch können maximal zwei Leuchtdioden 12, 13 elektrisch in Reihe geschaltet werden. Damit liegt die an den Leuchtdioden 12, 13 anliegende Spannung insgesamt unter 10V.

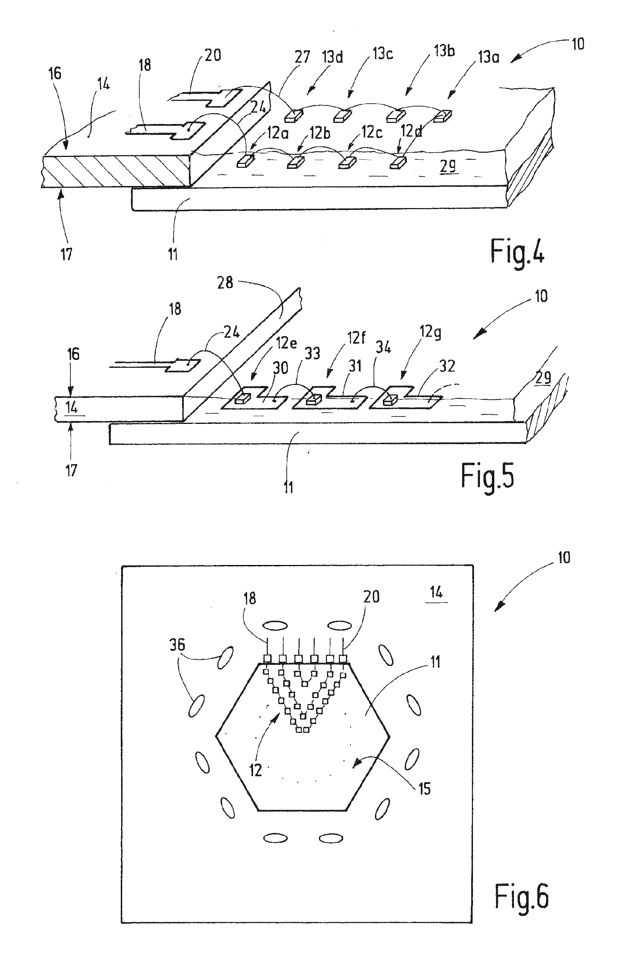

Sollten höhere Brennspannungen gewünscht werden, werden mehrere Leuchtdioden in Reihe geschaltet, wie dies in Figur 4 dargestellt ist. Soweit strukturell und funktionell gleiche oder ähnliche Elemente zur Anwendung kommen, wird auf die vorige Beschreibung verwiesen, wobei wiederum die bereits eingeführten Bezugszeichen zugrunde gelegt werden. Die vorstehend beschriebenen Varianten gelten auch hier. Speziell ist aber anzumerken, dass auf dem Reflektor 11 mehrere Leuchtdioden 12a bis 12d, 13a bis 13d, angeordnet sind. Diese weisen, anders als die Leuchtdioden 12, 13, keinen vertikalen, sondern einen horizontalen Stromdurchfluss auf und haben demzufolge, die stromzu- und -abführenden Kontakte an ihrer jeweiligen Oberseite. Es kann sich aber auch um Leuchtdioden mit vertikalem Stromdurchfluss handeln, bei denen die bodenseitige oder untere leitende Elektrodenschicht wieder an die Oberfläche geführt und dort kontaktiert ist. Während die Bonddrähte 24, 27, die in der Reihenschaltung endständigen Leuchtdioden 12a, 13b mit den Leiterbahnen 18, 20 verbinden, sind die Leuchtdioden 12a, 13b über weitere Bonddrähte mit den anderen Leuchtdioden 12b bis 12d, 13a bis 13c, in Reihe geschaltet. In dieser Ausführungsform hat der Reflektor 11 keine elektrische Funktion. Er kann als allgemeine Abschirmung dienen und mit den Substraten der Leuchtdioden 12a bis 12d, 13a bis 13d, elektrisch verbunden sein. Alternativ kann er von diesen Substraten auch isoliert sein. Zum Beispiel kann der Reflektor 11 dazu mit einer dünnen, durchsichtigen, nicht leitenden Schicht überzogen sein, die es gestattet, dass die Substrate der Leuchtdioden 12a bis 12d, 13a bis 13d, hochohmig auf verschiedenen Potentialen liegen. Dies kann insbesondere von Vorteil sein, wenn über der Reihenschaltung der Leuchtdioden 12a bis 13d hohe Spannungen von bspw. 100 V anstehen.

Figur 5 veranschaulicht ein Ausführungsbeispiel mit vertikal durchströmten Leuchtdioden 12e, 12f, 12g. Um die Leuchtdioden 12e bis 12g, sowie weitere nicht dargestellte Leuchtdioden miteinander in Reihe zu schalten können, sind auf dem Reflektor 11 von dem Reflektor 11 elektrisch isolierte, selbst stromleitenden Inseln 30, 31, 32 angeordnet, auf denen wiederum die Leuchtdioden 12e, 12f und 12g platziert sind. Die elektrisch leitenden Inseln 30, 31, 32 sind vorzugsweise nur wenig größer als die Chips der Leuchtdioden 12e, 12f, 12g. In Figur 5 ist die Größe der Inseln 30, 31, 32 zur Erleichterung der zeichnerischen Darstellung übertrieben groß veranschaulicht. Die Form der Inseln 30, 31, 32 kann in weiten Grenzen beliebig gewählt werden. Vorzugsweise umfasst die Insel eine Fläche zur Aufnahme der Leuchtdiode 12e, 12f oder 12g, sowie einen sich von dieser Fläche weg erstreckenden Fortsatz zur Kontaktierung eines Bonddrahts 33, 34. Jede Insel 30, 31, 32 kann aus einer dünnen Metallschicht bestehen, bspw. in Gestalt einer auf den Reflektor 11 aufgeklebten dünnen Metallfolie, einer aufgedruckten gegebenenfalls eingebrannten Metallschicht oder dergleichen. Jeder Insel 30, 31, 32 kann eine dünne Isolierschicht zugeordnet sein, die sich unter der Insel 30 bis 32 erstreckt und über deren Rand nur wenig herausragt. Die Isolierschicht kann eine Aluminiumoxydschicht, eine sonstige nicht leitende Oxydschicht, eine sonstige nicht leitende Keramikschicht, eine Kunststoffschicht oder dergleichen sein. Der Reflektor 11 kann an seiner reflektierenden den Leuchtdioden 30 bis 32 zugewandten Seite auch mit einer durchgehenden Isolierschicht, bspw. in Gestalt einer Oxydschicht, bspw. einer Aluminiumoxydschicht, einer Kunststofffolienschicht oder einer Kombination verschiedener Schichten versehen sein, die vorzugsweise hochtransparent sind. Die Leuchtdioden 12e bis 12g sind elektrisch mit ihren Inseln 30, 31, 32 verbunden. Bonddrähte 33, 34 verbinden wiederum die Insel 30 mit der Leuchtdiode 12f bzw. die Insel 31 mit der Leuchtdiode 12g.

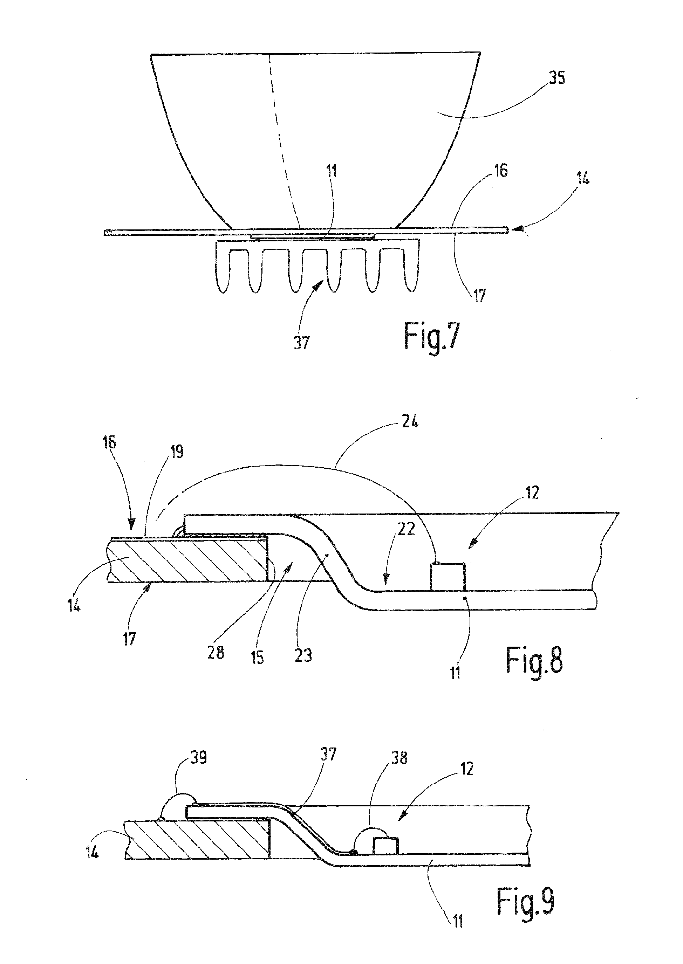

Figur 6 veranschaulicht eine praktische Ausführungsform einer Leuchtdiodenanordnung 10 mit einem hinter der Leiterplatte 14 montierten Reflektor 11. Auf diesen sind insgesamt mit 12 bezeichnete Leuchtdioden angeordnet, die serienweise in Reihe geschaltet sind. Zur Reihenschaltung kann jede der oben erläuterten Technologien dienen. Die jeweils endständigen LEDs jeder Reihenschaltung sind über Bonddrähte mit Leiterzügen 18, 20 der Leiterplatte 14 verbunden. Die Öffnung 15 kann einen polygonalen Umriss, bspw. einen Sechseckumriss aufweisen. Andere Umrissformen sind möglich. Um die Öffnung 15 herum sind mehrere Haltestrukturen zur Befestigung eines weiteren Reflektors, wie bspw. des aus Figur 7 ersichtlichen Reflektors 35 vorgesehen. Die Haltestrukturen können um die Öffnung 15 herum gruppierte weitere Öffnungen 36 sein, die entsprechende Fortsätze oder Füße des Reflektors 35 aufnehmen. Somit sitzt ein Teil der Reflektoranordnung, nämlich der Reflektor 35, vor der Leiterplatte, d.h. er erstreckt sich von der Vorderseite 16 weg während ein anderer Teil der Reflektoranordnung nämlich der Reflektor 11 an der Rückseite 17 der Leiterplatte 14 liegt. Der vorzugsweise ebene Reflektor 11 kann mit einem Kühlkörper 37 koppeln. Dieser kann mit dem Reflektor 11 verklebt oder gegen diesen gespannt sein.

An allen vorbeschriebenen Ausführungsformen der Erfindung sind Abwandlungen möglich. Eine erste Abwandlung kann in der Ausbildung des Reflektors 11 liegend. Figur 8 veranschaulicht ein Beispiel. Der Reflektor 11 kann wannenartig ausgebildet sein, indem sich sein Rand 23 in einem stumpfen Winkel zu der Chipaufnahmefläche 22 erstreckt. Damit kann ein ebener Abschnitt des Reflektors 11 "hinter" der Leiteplatte, also an deren Rückseite 17 angeordnet sein, während ein anderer Teil des Reflektors 11, nämlich ein Abschnitt des Rands 23, an der Vorderseite 16 der Leiterplatte 14 liegt. Der Rand 23 kann dort mit einem Leiterzug 19 verbunden sein. Zur Verbindung kann Lot oder Klebstoff dienen. Der Bonddraht 24 kann den Rand 23 überspannen und die Leuchtdiode 12 mit einem anderen Leiterzug verbinden. Bei dieser Ausführungsform hat der Reflektor 11 ähnlich wie bei der Ausführungsform nach Figur 1 bis 3 eine elektrische Funktion zur Kontaktierung der verschiedenen auf ihm angebrachten Leuchtdioden.

Es ist auch möglich, auf dem Reflektor 11 einen oder mehrere Leiterzüge 37 anzubringen, die der elektrischen Kontaktierung der Leuchtdiode sowie gegebenenfalls weiterer Leuchtdioden dienen. Der Leiterzug ist ein von dem Reflektor 11 elektrisch isolierter, selbst elektrisch leitender Leiterstreifen, der bspw. aufgeklebt oder aufgedruckt sein kann. Vorzugsweise ist er möglichst schmal, um die gewünschte Lichtreflexion des Reflektors 11 wenig oder nicht zu beeinträchtigen. Der Leiterzug 37 kann wiederum über Bonddrähte 38, 39 einerseits mit der Leuchtdiode 12 und andererseits mit einem externen Leiterzug der Leiterplatte 14 verbunden sein.

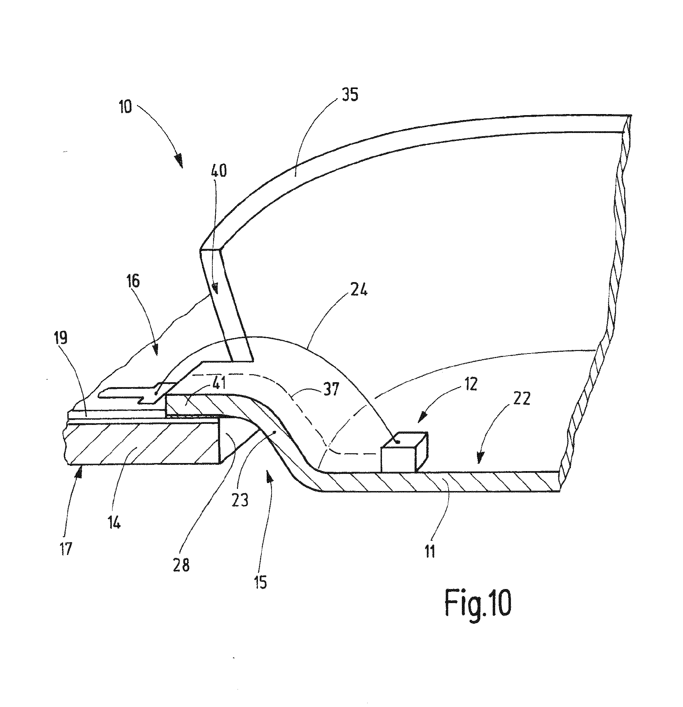

Während die Reflektoranordnung bei der Ausführungsform nach Figur 7 zumindest zweiteilig ausgebildet ist, kann sie auch mehrteilig ausgebildet sein. Der Reflektor 35 kann aus einzelnen neben einander angeordneten Reflektoren bestehen, wie in Figur 7 durch eine gestrichelte Trennlinie dargestellt ist. Die Reflektoranordnung kann aber auch einteilig ausgebildet sein. Ein solches Ausführungsbeispiel veranschaulicht Figur 10. Zur Beschreibung wird unter Zugrundelegung der bereits eingeführten Bezugszeichen auf die vorstehenden Ausführungsbeispiel verwiesen. Die dort jeweils erläuterten Merkmale und Aspekte können einzeln oder in Kombination auch bei der Ausführungsform nach Figur 10 verwirklicht sein, sofern sich aus der nachstehenden Beschreibung nichts anderes ergibt.

Die Leuchtdiodenanordnung 10 nach Figur 10 weist mindestens eine, vorzugsweise mehrere elektrisch parallel oder vorzugsweise in Reihe geschaltete Leuchtdioden auf, von denen in Figur 10 nur die Leuchtdiode 12 dargestellt ist. Sie kann mit dem Reflektor 11 elektrisch verbunden sein, wie es am Beispiel der Ausführungsform nach Figur 1 bis 3 erläutert worden ist. Sie kann von dem Reflektor 11 auch elektrisch isoliert sein, wie es bei den Ausführungsformen nach Figur 4 und 5 gegebenenfalls Figur 6 erläutert und auch bei Figur 9 möglich ist. Der Reflektor 11 ist hier mit dem Reflektor 35 vereinigt. Er erstreckt sich durch die Öffnung 15. Die so gebildete Reflektoreinheit weist mindestens eine Ausnehmung 40 auf, durch die sich der Bonddraht 24 von der Leuchtdiode 12 zu dem Leiterzug 19 erstreckt. Alternativ kann die Anordnung auch entsprechend Figur 9 getroffen werden, wobei sich der hier nur gestrichelt angedeutete Leiterzug 37 entlang des Rands 23 von einem äußeren Abschnitt desselben zu der Leuchtdiode erstreckt.

An der Ausnehmung 40 kann ein Teil des Rands 23 so nach außen gebogen sein, dass er wieder parallel zu dem Leuchtdiodenaufnahmeabschnitt 22 des Reflektors 11 führt. Dieser nach außen gebogen Abschnitt 41 kann zur Befestigung der Reflektoranordnung dienen und mit der Vorderseite 16 der Leiterplatte 14 durch Kleben, Löten und dergleichen mechanisch verbunden sein. Außerdem kann er zur Kontaktierung dienen, falls dies gewünscht ist.

Eine Leuchtdiodenanordnung 10 weist einen Reflektor auf, auf dem eine oder mehrere Leuchtdioden angeordnet sind. Der Reflektor ist mit einer Leiterplatte verbunden, die Leiterzüge zur Stromversorgung der Leuchtdiode trägt. Außerdem können auf der Leiterplatte elektronische Komponenten, bspw. zur Begrenzung oder Regelung des Leuchtdiodenstroms, angeordnet sein. Weitere elektronische Komponenten bspw. zur Temperaturüberwachung, Helligkeitsregelung, Farbüberwachung und dergleichen, können ebenfalls auf der Leiterplatte 14 platziert sein. An den an der Rückseite 17 angeordneten Reflektor 11 kann ein Kühlkörper 37 angeordnet sein. An der Vorderseite 16 der Leiterplatte 14 kann ebenfalls ein Reflektor 35 angeordnet sein. Die Leiterplatte 14 weist im Bereich des Reflektors 11 eine Öffnung 15 auf, innerhalb derer die Leuchtdioden 12, 13 usw. angeordnet sind.

### Bezugszeichenliste:

- 10: Leuchtdiodenanordnung
- 11: Reflektor
- 12, 13: Leuchtdiode 12a-d, 13a-d
- 14: Leiterplatte
- 15: Ausnehmung
- 16: Vorderseite
- 17: Rückseite
- 18 - 21: Leiterzüge
- 22: Chipaufnahmefläche
- 23: Rand
- 24: Bonddraht
- 25: Lot
- 26: Durchkontaktierung
- 27: Bonddraht
- 28: Randfläche
- 29: Verguss
- 30 - 32: elektrisch leitende Inseln
- 33, 34: Bonddraht
- 35: Reflektor
- 36: Öffnungen
- 37: Leiterzug
- 38, 39: Bonddrähte
- 40: Ausnehmung
- 41: Abschnitt

## Patentansprüche

1. Leuchtdiodenanordnung (10), insbesondere zu Beleuchtungszwecken,
mit einem Reflektor (11),
mit wenigstens einer Leuchtdiode (12), die auf dem Reflektor (11) angeordnet ist,
mit einer Leiterplatte (14), die mit dem Reflektor (11) verbunden ist,
mit wenigstens einem Bonddraht (24), der mit einem Ende an der Leuchtdiode (12) und mit seinem anderen Ende an einem Leiterzug (20) der Leiterplatte (14) befestigt ist.

2. Leuchtdiodenanordnung nach Anspruch 1, **dadurch gekennzeichnet, dass** der Reflektor (11) eine spiegelnde Oberfläche aufweist.

3. Leuchtdiodenanordnung nach einem der vorstehenden Ansprüche, **dadurch gekennzeichnet, dass** der Reflektor (11) eine diffus reflektierende Oberfläche aufweist.

4. Leuchtdiodenanordnung nach einem der vorstehenden Ansprüche, **dadurch gekennzeichnet, dass** der Reflektor (11) eine ebene Chipaufnahmefläche (22) und einen Rand (23) aufweist, der die Chipaufnahmefläche (22) umgibt.

5. Leuchtdiodenanordnung nach Anspruch 4, **dadurch gekennzeichnet, dass** die Chipaufnahmefläche (22) und der Rand (23) in einer gemeinsamen Ebene liegen.

6. Leuchtdiodenanordnung nach Anspruch 4, **dadurch gekennzeichnet, dass** der Rand (23) an wenigsten einer Stelle einen abgewinkelten Abschnitt (41) aufweist.

7. Leuchtdiodenanordnung nach einem der vorstehenden Ansprüche, **dadurch gekennzeichnet, dass** der Reflektor (11) an einer ersten Seite (17) der Leiterplatte (14) angeordnet ist und dass der mit dem Bonddraht (24) verbundene Leiterzug (20) an einer anderen Seite (16) der Leiterplatte (14) angeordnet ist.

8. Leuchtdiodenanordnung nach einem der vorstehenden Ansprüchel, **dadurch gekennzeichnet, dass** sich der Bonddraht (24) durch eine Öffnung (40) erstreckt, die in dem Reflektor (11) ausgebildet ist.

9. Leuchtdiodenanordnung nach einem der vorstehenden Ansprüchel, **dadurch gekennzeichnet, dass** der Reflektor (11) eine Koppelfläche für einen Kühlkörper (37) aufweist.

10. Leuchtdiodenanordnung nach einem der vorstehenden Ansprüchel, **dadurch gekennzeichnet, dass** sich der Reflektor (11) durch eine Öffnung (15) der Leiterplatte (14) hindurch erstreckt.
